Europäisches Patentamt

European Patent Office

Office européen des brevets

(11) Publication number: **0 646 954 A2**

# EUROPEAN PATENT APPLICATION

(21) Application number: **94111619.6**

(22) Date of filing: **26.07.94**

(51) Int. Cl.6: **H01L 21/48**

(30) Priority: **29.09.93 US 128524**

(43) Date of publication of application:
**05.04.95 Bulletin 95/14**

(84) Designated Contracting States:
**DE GB**

(71) Applicant: **FUJITSU LIMITED**
**1015, Kamikodanaka**
**Nakahara-ku**
**Kawasaki-shi**
**Kanagawa 211 (JP)**

(72) Inventor: **Wang, Wen-Chow Vincent**
**18457 Edminton Drive**
**Cupertino,**
**California 95014 (US)**
Inventor: **Chou, William Tai-Hua**
**11551 Lake Spring Court**
**Cupertino,**
**California 95014 (US)**

(74) Representative: **Stebbing, Timothy Charles et al**
**Haseltine Lake & Co.**
**Hazlitt House**
**28 Southampton Buildings**
**Chancery Lane**
**London WC2A 1AT (GB)**

(54) **Low-defect one-step etching process.**

(57) A method of forming high aspect ratio vias (376, 377, 378) through a plurality of polymeric dielectric layers (155a ... 155i) in a multichip module, and a multichip module structure incorporating such high aspect ratio vias are disclosed. Preferably, electron cyclotron resonance (ECR) etching is used to form the vias, at least some of which have aspect ratios greater than 3:1 and heights greater than 20 microns. According to the present invention, vias which extend to different patterned conductive layers (110, 115, 120) within the multichip module may be formed in a single step. The method is particularly useful for forming vias to capacitor plate layers within the multichip module because it substantially eliminates the risk of shorting due to defects in the mask layer when vias are formed solely through very thin dielectric layers between capacitor plates.

FIG. 3

Rank Xerox (UK) Business Services
(3.10/3.09/3.3.4)

The present invention relates generally to the packaging of semiconductor devices, and is specifically related to methods of forming high aspect ratio vias in semiconductor device packages, and to a multilayered packaging structure incorporating high aspect ratio vias.

The device density of semiconductor integrated circuit chips (IC chips) has dramatically increased in the years since their initial introduction, such that millions of discrete components are now routinely included on a single IC chip. In addition, the clock speeds at which such chips operate has dramatically increased, such that digital signals at microwave frequencies are now heing used in high performance systems. The increasing complexity of the devices being used, along with the higher speeds of such devices, have challenged the traditional methods of packaging chips.

Various multichip module structures have been developed to address the need to provide improved packaging for modern high-performance IC chips. One important reason for using multichip modules is to minimize signal propagation delay thereby improving system performance. Multichip module structures involve mounting a plurality of IC chips on one or more substrates to form a two- or three-dimensional array of chips. A substrate of a multichip module may include means for delivering power and ground to the individual chips mounted on the substrate, as well as signal paths for interconnecting the chips on the module, and for interconnecting these chips with other devices that are external to the module. In some instances, the delivery of power to the chips requires that more than one voltage level be provided. Finally, the substrate may also include by-pass capacitors to reduce DC noise associated with high speed switching of power to the chips. Due to the complexity of providing all of the foregoing to each of the chips mounted on a substrate, such substrates are often fabricated as multilayer structures, with various patterned conductive layers being used for the required voltages and ground connections, and other conductive layers being used for signal lines. As described, at least two layers of patterned conductive material may be dedicated to forming by-pass capacitors. Interleaved between the patterned conductive layers are insulation layers to prevent shorting between the conductive layers.

Initially, the primary technology for forming multilayered multi-chip module substrates was ceramic-based, (sometimes referred to as "co-fired" ceramic). More recently, thin film structures, primarily based on the use of copper and polyimide, have become important due to the smaller line widths and layer thicknesses that can be realized, as well as the fact that polyimide has a more favorable dielectric constant than most ceramics. In addition, copper/polyimide structures are readily grown on silicon wafers, such that the much of the equipment and some of the techniques used in connection with the processing of semiconductor wafers can be employed in the fabrication of thin film multichip module substrates. Other multichip modules have been developed wherein the two technologies have been combined in multilayered structures comprising both ceramic portions and copper/polyimide portions.

Multilayered multichip modules, as just described, require means for connecting the various signal lines, power lines, ground lines and capacitors to a surface of the structure so that they can be coupled to the IC chips mounted on the module. Such connections between the various layers and the surface of the module are commonly made using "vias" that run from the various layers to the surface. Other vias may be used within the structure to interconnect layers, without extending to the surface of the structure for direct coupling to an IC chip or external device. In the typical prior art, coupling of a layer to the surface was made by forming a series of vias, each of which only extended the distance between two layers, but which were electrically connected so as to provide a circuit path between one or more conductive layers and a pad on the upper surface of the multichip module for connection to an IC chip or external device.

A via typically comprises an aperture formed through one or more layers as by removal of some of the material of the layer(s), which is then filled with a conductive material. Thus, a via has upper and lower ends at either side of the layer(s) through which it extends and is able to conduct electricity between these ends. The term via is sometimes used in the art to refer only to the aperture that is formed through one or more layers, with the understanding that the aperture is later to be filled with a conductive material. The particular usage of the word is generally obvious from the context, and both usages are employed in this specification.

As discussed, one of the reasons for using multichip modules is due to the high number of interconnections that must be made with highly complex IC chips. When a large number of complex chips must be interconnected, the architecture of the multilayered chip module is commensurately complex. The need to provide separate vertical pathways through multiple layers of material presents designers with difficult topographical problems compounding the complexity of the structure. Area or "real estate" on the surface and within the layers of the module is at a premium, such that it is desirable to form vias which occupy the minimum amount of area as possible. To do this it is desirable to form vias having a very high aspect ratio, *i.e.,* the ratio of via depth to average via width or diameter. Unfortunately, heretofore, the etching processes which have been used to form vias have not been able to attain high aspect ratios due, in large part, because the etching processes applied have not been sufficiently anisotropic. To form a high aspect ratio via, it is necessary to etch preferentially in the downward direction, without etching or undercutting in the lateral direction.

Various methods are known in the prior art for forming vias in multichip modules. In ceramic structures where the dimensions are relatively large, holes may simply be punched or otherwise mechanically formed in the various ceramic green sheet layers before they are hardened. Laser drilling of vias is sometimes used for forming vias in both ceramic and thin film structures. Finally, wet and dry etching techniques may be used, and are particularly common for forming holes in polyimide. While the etching techniques that have been employed in the prior art are similar in may respects to etching techniques used in connection with integrated circuit fabrication, there is a significant difference in scale of the two types of structures, such that adjustments have to be made, and not all techniques are transferable. For example, a polyimide layer used in a multichip module may be an order of magnitude or more thicker than a dielectric layer used in fabricating an IC chip. Likewise, the diameter of the via may be an order of magnitude or more greater than a via used in an IC chip.

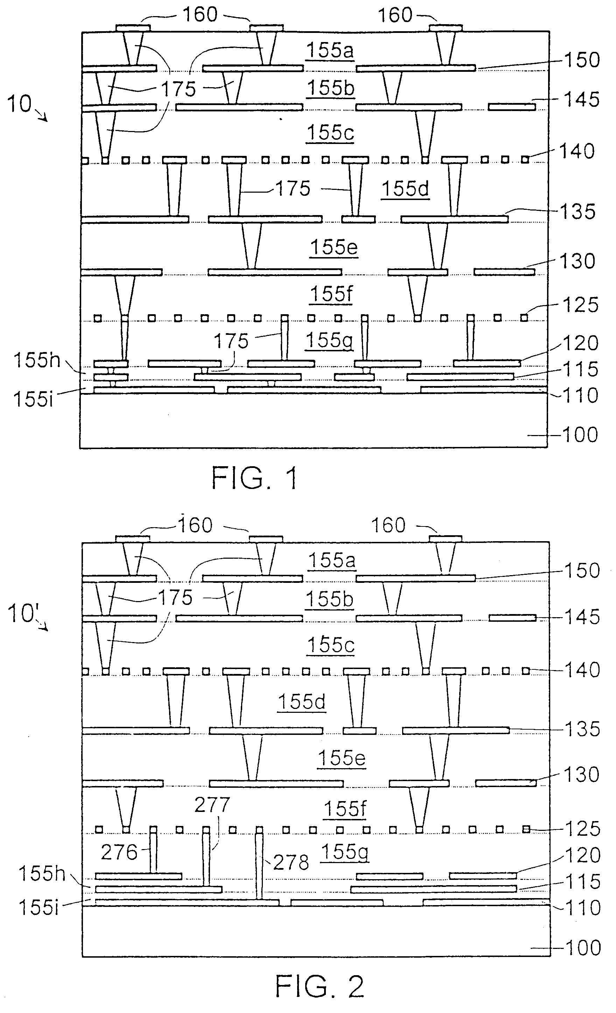

FIG. 1 is a partial cross sectional view of a thin film multilayered multichip module substrate 10 of the type known in the prior art. A number of individual layers are fabricated on top of a surface of a relatively thick substrate 100. For example, such layers may comprise interleaved layers of copper and polyimide, as described in greater detail below, which are formed on a silicon wafer. FIG. 1 shows nine patterned conductive layers, 110, 125, 120, 125, 130, 135, 140, 145 and 150, separated by layers of an insulating polymeric material 155a - 155i, respectively, such as a polyimide. Thus, there is a polyimide layer associated with each conductive layer shown in FIG. 1. The cumulative thickness of the module layers may be of the order of 100 - 150 microns, (not including the thickness of base substrate 100).

On the upper surface of multichip module 10 are a plurality of contact pads 160 for coupling IC chips to module 10. Similar pads may be used for coupling the multichip module to external devices. A number of well-known methods are available for connecting IC chips to a substrate including wire bonding and flip-chip bonding using, for example, solder bumps. Such methods are considered beyond the scope of the present invention and will not be discussed further as they are well-known in the art. In addition, intermediate or "interposer" substrates may be mounted between the multichip module substrate and one or more of the IC chips coupled thereto. Again, a more thorough description of the use of interposer substrates is not necessary for an understanding of the present invention.

The patterned conductive layers in the module depicted in FIG. 1 may comprise, for example, three capacitor plate layers 110, 115 and 120, which are coupled to the power supply to the chips, y-direction signal layers 125 and 140, x-direction signal layers 150, 145, and ground layers 135 and 130. Those skilled in the art will recognize that each of the patterned conductive layers may also have portions that are used to contact vias in the adjacent dielectric layers to provide a portion of a conductive path from a patterned conductive layer below to the surface of the multichip module above. A typical method of fabricating the patterned conductive layers is as follows: A thin film of metal, such as copper, is deposited over the entire exposed surface of the substrate using well-known methods such as sputtering or evaporation. A photoresist is applied onto the surface of the metal layer and is hardened by soft baking. The resist is then printed (*i.e.,* exposed to light through a mask defining the desired pattern), and developed so as to uncover selected surfaces of the metal layer. The remaining photoresist is then further hardened ("hard baked") and the exposed surfaces of the metal are etched away using standard etch techniques, leaving a patterned metal layer. The remaining photoresist is removed, *i.e.,* stripped.

After a patterned conductive layer is formed in this manner, a polyimide layer 155 is deposited on top of the metal layer, as by applying a liquid precursor compound onto the top surface of the substrate, spinning the substrate to obtain a desired uniform thickness, and thereafter curing the layer to polymerize the compound. In the prior art, before applying the next metal layer, vias 175 were formed in the polyimide layer using standard photolithographic techniques. The typical process for forming vias 175 in a polyimide layer 155 is, however, somewhat more complicated than that described for patterning a metal layer, in that an etch mask, typically metallic, must be formed on the surface of the polyimide. Thus, a typical prior art process for forming vias might involve dielectric deposition, etch mask deposition, resist patterning (resist deposition, soft bake, print, develop, hard bake), mask patterning, dielectric etching to form the vias, mask stripping and via filling. Although tile layers in FIG. 1 are not drawn to scale in order to facilitate understanding, the polyimide layers are generally appreciably thicker than the patterned conductive layers, with the exception, however, that the layer thickness of polyimide is reduced between the capacitor layers to increase capacitance.

Thus, in the prior art, there are a number of processing steps associated with each conductive layer and each dielectric layer, such that fabrication of a multilayered structure is a tedious, time consuming and exacting process. Of course, there is a risk of damage or failure associated with each processing step so that the overall yield of usable substrates depends on the number of processing steps involved.

As has been described and as shown in FIG. 1, the typical prior art process for fabricating a copper/polyimide multilayered multichip module structure comprises formation of vias 175 after each dielectric layer is formed, such that each via extends only between adjacent conductive layers. Thus, to form a conductive path from a metal layer (other than the uppermost conductive layer) to the surface of the multichip module requires multiple via formation processes. In some designs, the electrical path between a portion of a conductive layer and the surface of the multichip module may be somewhat circuitous, with using vias in different layers at different locations, as shown in FIG. 1. In other designs, a via formed in one dielectric layer overlies a via formed in the dielectric layer directly beneath it, and the resulting structure may be thought of as a single via extending through multiple layers. However, such a structure still requires multiple via formation and the related processing complexity. Manufacturing defects may arise if the alignment between adjacent layers is not precise, or if the interface between two separately formed but connected vias is poor, thereby affecting the electrical conductivity of the structure. A via formed in multiple segments in this manner will not have a smoothly continuous wall since there will be an interface at each of the layers.

Laser drilling has been used in the prior art to form vias through multiple layers of material. However, laser drilling has not gained practical importance since only one hole can be drilled at a time, making it very time consuming to drill the very large number of via holes that are associated with a complex multichip module.

While the thicknesses of the various layers shown in FIG. 1 are not to scale, when capacitor structures are formed within the multichip module, as shown, the thickness of the dielectric layers (*i.e.*, layers 155h and 155i) between the plates of the capacitors is minimized. For a parallel plate capacitor, the capacitance (C) of the capacitor is directly proportional to the dielectric constant ($k$) of the dielectric material between the capacitor plates and the overlapping area between the plates (A), while inversely proportional to the separation between the plates (*t*), *i.e.*, the thickness of the dielectric material. This may be expressed by the well-known formula, $C = kA/t$. Thus, a high capacitance capacitor requires a combination of one or more of a material having a high dielectric constant, a large overlapping area of opposing plates, and a thin dielectric layer. However, it is difficult to form very thin dielectric layers, each of which has vias formed therein, between patterned conductive layers in a multichip module structure of the type described, and so the manufacturing yield of such devices is low. The difficulty usually arises during the etching of the vias in the thin dielectric layers due to small defects, *i.e.*, small holes or micropores, in the mask layers used for patterning the vias. When etching is performed, these defects effectively form unintended vias creating shorts between the capacitor plates.

As shown in FIG. 1, more than two layers of patterned conductive material are often required for capacitor plates. The need for more than two layers arises from the fact that, most of the time, more than one voltage is being supplied to the IC chips coupled to the multichip module, creating the need for separate capacitor plates for each voltage level supplied. In addition, the overall area of overlapping capacitor plates (A) can be increased by adding plates at different levels.

Accordingly, it is an object of the present invention to provide a method of forming high-aspect ratio vias in multichip module which simplifies the number of processing steps required to fabricate the module.

Another object of the present invention is to provide a one-step method of forming a plurality of high aspect ratio vias of different lengths that extend through multiple layers.

Still another object of the present invention is to provide a highly anisotropic method of etching vias in relatively thick layers of polyimide, such that there is very little undercutting or lateral etching of the via openings as the etching process is conducted.

Yet another object of the present invention is to provide a novel multichip module substrate that is simple to fabricate and which minimizes the area of the substrate that is occupied by vias.

A further object of the present invention is to provide a method for forming capacitor plates in a multichip module which increases the manufacturing yield without increasing the thickness of the dielectric layer between capacitor plates.

The foregoing objects of the invention, along with others that will become apparent to those skilled in the art upon reading the present specification, are realized in a novel one-step method of forming high-aspect ratio vias in a multichip module, and in a multichip module structure incorporating vias formed in accordance with the inventive process. In one aspect, the process of the present invention comprises using electron cyclotron resonance (ECR) etching to etch high aspect ratio vias in a relatively thick layer of polymeric material, such as polyimide, using a etch mask. In another aspect, the present invention comprises the steps of providing a multilayered substrate having a plurality of conductive layers at different levels therein, said conductive layers being separated by insulating layers, positioning a mask in proximity to the top surface of said multilayered substrate, said mask having a plurality of openings corresponding to vias to be formed within said multilayered substrate, and simultaneously removing the insulating material beneath each of said openings such that vias having substantially the same dimensions as the overlying openings are formed, said vias extending from the conductive layers to the top surface of the multilayered substrate. The step of simultaneously removing said insulating material is performed using either ECR etching or reactive ion etching (RIE). The present invention is useful with vias having a height greater than 20 microns and an aspect ratio greater than 3 to 1. Preferably, the insulating material is a polymeric material such as a polyimide. The present invention also encompasses a multilayered substrate for a multichip module, comprising a plurality of conductive layers, a plurality of insulating layers interleaved between said conductive layers, a plurality of vias formed within said substrate, each said via extending from a substantially planar surface to one of said conductive layers, such that said vias are of different heights, at least some of said vias having an aspect ratio greater that 3 to 1 and a height greater than 20 microns, each of said vias having a smoothly continuous wall.

Reference is made, by way of example, to the accompanying drawings in which:

FIG. 1 is a schematic cross-sectional representation of a thin film multichip module substrate of the type known in the prior art.

FIG. 2 is a schematic cross-sectional representation of a thin film multichip module substrate of one embodiment of the present invention.

FIG. 3 is a schematic cross-sectional representation of a thin film multichip module substrate in accordance with another embodiment of the present invention.

FIG. 4 is a flow chart of the method of the present invention.

FIG. 5 is a scanning electron micrograph of a high aspect ratio via formed in accordance with the present invention.

The present invention is directed to a method of forming vias in a multilayered multichip module substrate, and is particularly useful in connection with forming vias to patterned conductive layers used as bypass capacitor layers formed within the substrate. The method is particularly useful for avoiding the creation of defects in the thin dielectric layer between the plates of the capacitor. The present invention departs from the prior art method of forming vias after each dielectric layer is formed. Rather, in accordance with the present invention, only after several or all of the dielectric layers are formed are the vias formed. Deferring the formation of vias until several or all of the layers of dielectric are formed not only increases the manufacturing yield of capacitor structures, but also appreciably reduces the number of processing steps required to form the multichip module substrate. In particular, the process of the present invention eliminates large number of processing steps needed to separately form vias in each layer of dielectric.

The requirements for forming vias through multiple layers of dielectric include the need to be able to effectively etch through relatively large thickness of material, e.g., more than 20 microns, while maintaining a very high aspect ratio, e.g., a ratio of via height to average via diameter greater than 3:1. The inventors have discovered that electron cyclotron resonance (ECR) etching is a highly suitable etching process for carrying out the present invention in that it has been shown by the inventors to exhibit highly anisotropic etching through relatively large thicknesses of polyimide. The inventors have successfully used ECR etching to form vias in polyimide layers greater than 20 microns, with no substantial undercutting of the mask layer and no substantial widening of the via. Thus, the via that is formed through a relatively thick polyimide layer has a diameter at its upper end which is substantially the same size as the aperture in the mask layer used to define the via.

ECR is a relatively new semiconductor processing technique that is only beginning to gain acceptance. As far as the inventors are aware while ECR has been used for etching thin layers during semiconductor device fabrication, it has not, heretofore, been applied to the fabrication of multichip modules. It is noted that tile film thicknesses in a multichip module are greater by as much as an order of magnitude or more than the film thicknesses associated with semiconductor devices. Accordingly, the results obtained by the inventors by applying ECR to etching vias in multichip modules were unexpected and surprising.

FIG. 2 is a schematic cross-sectional representation of a thin film copper polyimide multichip module substrate 10' according to one embodiment of the present invention. Except as hereinafter described, substrate 10' is the same as substrate 10 shown in FIG. 1, and the same numbers have been used to represent common features of the two structures. The vias 175 within a layer of substrate 10 of FIG. 1 are formed immediately after the dielectric layer 155 in which they are present is formed, so that the complex process for forming vias is repeated for each dielectric layer. As schematically shown in FIG. 1, vias 175 between the capacitor layers 110, 115 and 120, are relatively short because of the thinness of the dielectric layers 155h and 155i they are formed in.

In the embodiment of the present invention depicted in FIG. 2, no vias are formed solely in thin dielectric layers 155h and 155i between the plates of the bypass capacitors. Instead, in accordance with the one-step etch process of the present invention, vias 276, 277 and 278 are formed after all of the capacitor structure is formed. In the embodiment of FIG. 2, vias 276, 277 and 278 extend from the top of relatively thick dielectric layer 155g ,to different plate levels, *i.e.,* different patterned conductive layers. Thus, via 276 extends only through dielectric layer 155g to patterned conductive layer 120; via 277 extends through dielectric layers 155g and 155h to patterned conductive layer 115; and via 278 extends through dielectric layers 155g, 155h, and 155i to patterned conductive layer 110. Even though these vias are of different length and, accordingly, some of them extend through multiple layers of dielectric material, they are all formed in a single step etching process as described hereinbelow.

As described above, there is a risk of shorting associated with the formation of vias in thin dielectric layers. The method of forming vias of the present invention allows vias to be formed having different lengths without substantial undercutting or lateral growth of a shorter via after it has reached a conductive layer and while other vias are continuing to be formed. This allows via diameters to be precisely controlled such that the electrical properties of the vias can be kept highly uniform.

In the embodiment of FIG. 2, the vias connecting the capacitor plates are formed only after the relatively thick dielectric layer 155g above the capacitor structure has been formed. Thus, the risk of forming unintended vias in the relatively thin dielectric layers between the capacitor's plates is effectively eliminated since no etch mask is ever formed directly on top of these thin layers. Any etching that occurs due to micropores in the mask layer will proceed at a relatively slow rate and will not extend to a conductive layer. Hence, such defects will not cause shorting. In addition, the one-step etch method of the present invention saves numerous processing steps associated with forming vias after each dielectric layer is formed.

In the embodiment of FIG. 2, the vias formed using the one-step etch method of the present invention are only those used for coupling to the capacitor layers. This is because in the prior art the risk of manufacturing defects is greatest with the very short vias used to connect to the capacitor layers. In the FIG. 2 embodiment, after the capacitor layers and the overlying thick polyimide layer 155g are formed, and vias 276, 277 and 278 are formed, the remaining structure of the multichip module, *i.e.,* patterned conductive layers 125, 130, 135, 140, 145 and 150, interleaved dielectric layers 155a - 155f, and contact pads 160, are formed in a conventional manner as described in connection with FIG. 1. In addition, the remaining dielectric layers may have vias 175 formed in them in accordance with the prior art.

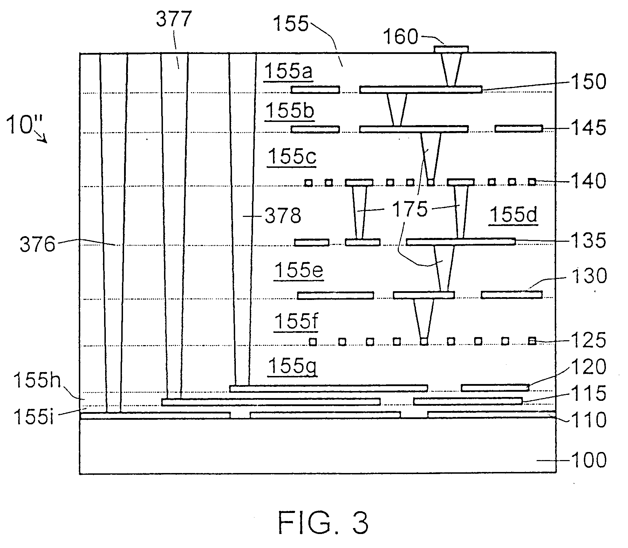

Another embodiment of the present invention is shown in FIG. 3, to which we now turn. In the embodiment depicted in FIG. 3, vias 376, 377 and 378, coupling the capacitor plates to the surface of the multichip module, are formed after all of the layers of the module have been formed. Thus, vias 376, 377 and 378 all extend through dielectric layers 155a - 155g. In addition, vias 376 and 377 also extend through dielectric layer 155h, and via 376 further extends through layer 155i. Again, although vias 367, 377 and 378 are formed in a single step etch process, as described in greater detail below, each of them has a different length, with its lower end terminating at a patterned conductive layer at a different level in the multichip module structure. The length of these vias may exceed 100 microns. When etching is conducted in accordance with the method of the present invention, high aspect ratio vias having different lengths may, nonetheless, be formed having substantially the same diameter. As shown in the portion of FIG. 3 away from vias 376, 377 and 378, the remaining structure of tile multichip module of the present invention may be formed in a conventional manner.

Those skilled in the art will appreciate that although three vias and three capacitor layers of patterned metal have been shown for exemplary purposes, fewer or more layers can be connected by high aspect ratio vias in accordance with the present invention, and that more than one via can be employed in connection with each layer. For example, up to five capacitor layers are now being contemplated by the inventors, and the present invention allows one-step etching to form vias to all of them. Likewise, although the high aspect ratio vias extending through multiple layers of the present invention are shown, in the illustrated embodiments, as being used only for coupling to the capacitor plate layers, such vias can be used in connection with any of the patterned conductive layers in the module.

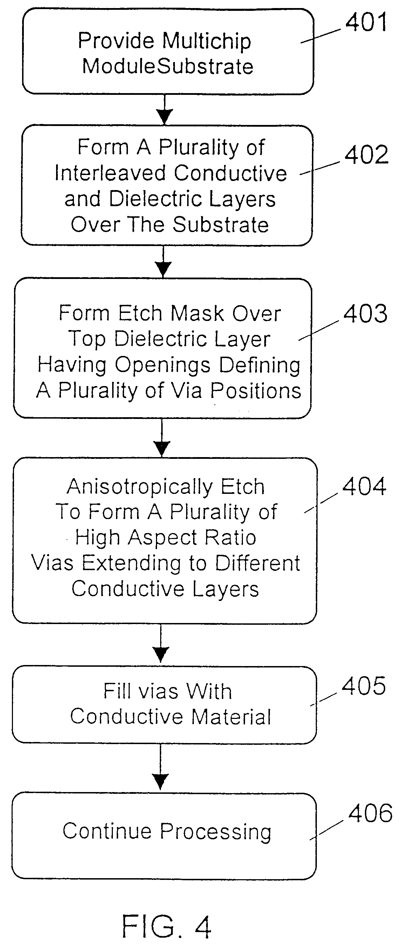

We now turn to FIG. 4 which is a flow chart of the process of the present invention. The process starts at step 401 wherein a multichip module substrate is provided. This substrate is conventional and may be made of silicon, ceramic, sapphire, metal (*e.g.,* copper or aluminum), or other material. Likewise, the steps for preparing the substrate are conventional. For purposes of the present invention, the substrate provided at step 401 may have various layers of conductive and/or dielectric material already formed thereon.

At step 402, a plurality of interleaved patterned conductive layers and dielectric layers are formed on the substrate in a conventional manner, except that the prior art step of forming vias in each dielectric layer after it is formed is omitted. Thus, a first conductive layer is deposited and patterned and a first dielectric layer is formed on top of the first patterned layer. It is noted that the dielectric layer will fill in any areas removed during the patterning of the conductive layer, such that in the areas where the conductive layer has been removed the dielectric layer is thicker. Thereafter, additional patterned conductive layers and layers of dielectric material are sequentially deposited.

The present invention is primarily intended for use in connection with thin film multichip module substrates wherein the patterned conductive layers are formed of a metal such as copper, and the dielectric layers are formed of a polymeric material such as a polyimide. The term "polyimide" actually refers to a class of polymeric compounds that have found widespread use in the electronics industry. In thin film multichip modules of the type described, the patterned metal layers may typically have a thickness on the order of 1 - 5 microns, while the polyimide layers may have a thickness in the range of 3 - 50 microns. As described above, thin polyimide layers (*i.e.,* of the order of 3 microns thick) are used to separate capacitor plates, while relatively thick polyimide layers, *e.g.,* greater than 10 microns, are used to separate other structures in the substrate.

Since the vias of the present invention extend through multiple dielectric layers, the metal layers are patterned so that no metal is present in areas where the extended vias are to be formed. However, as described in connection with FIGS. 2 and 3, in accordance with the present invention, different vias will extend to different conductive layers.

At step 403, after a plurality of interleaved conductive and dielectric layers have been formed, a mask layer is deposited on the uppermost dielectric layer. The mask layer must have the property of being resistant to the particular etch process used, may be deposited by conventional means such as sputtering, evaporation or chemical vapor deposition (CVD). For example, when using ECR with oxygen as the reactant species, a layer of titanium (which may be deposited by sputtering) or of silicon dioxide (deposited by CVD) is suitable as an etch mask material. Aluminum is also commonly used as a mask layer and is usable when a halogen-based etchant is used. Such mask layers are typically about a micron or less in thickness, with titanium functioning with thicknesses less that one quarter micron. The mask layer is then patterned using conventional photolithographic techniques to create apertures at locations in the mask layer where vias are to be formed. Such apertures may be substantially round, with a diameter on the order of 10 microns or less. It is noted that, while this diameter is relatively large compared to via diameters used in modern IC chips, it is quite small in relation to the prior art thin film multichip module packaging technology.

At step 404, a highly anisotropic etch process is used to simultaneously form a plurality of vias in the exposed areas of the dielectric layers defined by the apertures in the etch mask. In the preferred embodiment of the present invention, ECR is used for etching. In ECR, microwave rf energy (*e.g.,* at 2.45 GHz) is applied in a low-pressure environment (*e.g.,* 0.5 - 2.0 mTorr) to create a plasma which is confined by a static magnetic field. The plasma is created in a mixture of an inert support gas, such as argon, and one or more reactant species such as gaseous halogen or oxygen compounds, which attack and remove the exposed surfaces to be etched. A bias voltage is used to attract the ionized reactant species to the surface of the substrate being processed. The bias voltage may be obtained by applying either a supplemental rf voltage or a DC voltage to the substrate. In order to remove reaction compounds and supply fresh reactant gas, the mixture of inert support gas and reactant gas continuously flows through the system as etching proceeds.

As is known in the art, the optimal etching parameters for a given process are highly dependent on the nature and thicknesses of the dielectric layers being etched and cannot be generalized. For example, different polyimide species exhibit different etch behavior. Factors such as reactant species and percentage of reactant gas in relation to support gas, plasma power, bias voltage, magnetic field strength, chamber pressure, gas flow rate, substrate-to-source spacing, and other hardware specific factors are all significant. Those skilled in the art will recognize that routine experimentation is required to optimize the reaction parameters. A suitable ECR system for practicing the present invention is commercially available from the PlasmaTherm company, which is located in Petersberg, Florida. It is understood by the inventors that, heretofore, ECR has not been used to etch through relatively thick layers of polyimide.

It is believed that the suitably highly anisotropic behavior of the ECR etching stems from the highly directional flow of reactant ions from the plasma to the surfaces to be etched. Due to the high rate at which the field direction changes when operating at microwave frequencies, ions trapped in the plasma do not have high average velocity in any direction. The bias voltage, typically at a level of a few hundred volts, extracts the ions from the plasma. Since the ions otherwise do not have high velocity, they tend to follow the field lines down into the via opening and travel straight down the opening to the bottom without contacting the sidewalls. (Contact between the etchant gas and the sidewalls of the via causes etching of the sidewalls, undercutting the mask opening and widening the via.) The low operating pressure of the process means that the mean-free-path of the gas ions is relatively long so that gas collisions are infrequent in the dimensions of a via, *i.e.,* a ion travelling down a via is unlikely to collide with another ion or molecule and be scattered so as to contact a sidewall.

While ECR is preferred for implementing the process of the present invention, reactive ion etching (RIE) can also be used, so long as the process parameters are suitably adjusted so that highly anisotropic etching is obtained. Depending on the operating conditions, RIE can either be isotropic or anisotropic. Nonetheless, ECR is preferred because it gives independent control of the ion bombardment energy (*i.e.,* the bias voltage) and the energy supplied to the plasma. In RIE, the rf voltage used to create the plasma is also used to bias the substrate and, thus, it is not possible to independently control these important etch parameters. Moreover, ECR operates at lower pressures hence providing a longer mean-free-path and less scattering; provides higher levels of ionization hence a higher plasma density; and has an overall lower plasma potential decreasing the risk of damage to the substrate in contact with the plasma. These factors mean, *inter alia*, that ECR is capable of etching high aspect ratio vias in accordance with the present invention at a higher rate, and that the vias have improved characteristics, *i.e.,* steeper sidewalls, less undercut, etc.

Highly anisotropic etching is important for a number of reasons. First, if the etch process is not highly anisotropic it will be impossible to form high aspect ratio vias since, even if a mask is used, the vias will widen as etching proceeds. Again, this is particularly a problem when etching through a relatively thick layer. Second, the wider vias that naturally result when using an etch process that is not highly anisotropic take up more real estate on and within the multichip module, which is undesirable.

Finally, when undercutting is a problem it is hard to reliably form vias of differing lengths all of which have similar and predictable electrical properties. The amount of undercutting and lateral growth that will occur varies depending on the length of the vias, with proportionally greater lateral growth occurring in short vias. Thus, when a highly anisotropic etch process is not used, if one were to try to simultaneously etch a relatively short via and a relatively long via, by the time the long via was completed the short via would be unacceptably wide.

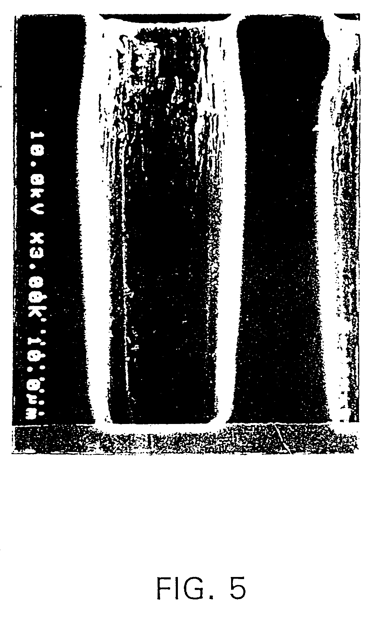

FIG. 5 is a scanning electron micrograph of a high aspect ratio via in polyimide, made in accordance with the present invention. The via shown in FIG. 5 has an opening with is approximately 10 - 11 microns in diameter and a depth of approximately 35 microns, such that it has an aspect ratio of approximately 3:1. It is noted that the sidewalls of the via are almost completely vertical and, as a consequence, there is little difference in the diameter of the via from top to bottom.

Returning to FIG. 4, the etch process is continued until a layer of conductive metal is reached, at which time the etching stops due to the inability of the etchant species to attack the metal of the patterned conductive layer. Thus, for example, when etching the exemplary structure of FIG. 2 using the method of the present invention, wherein three vias are being formed, *i.e.,* vias 276, 277 and 278, the etching process is first completed with via 276 which extend only through polyimide layer 155g. When via 276 reaches metal layer 120 etching stops within that via. Assuming that the vias are all substantially the same diameter, such that the etch rate is substantially the same, etching continues in vias 277 and 278 since they extend through additional layers. Notably, the etch method of the present invention is so highly anisotropic that via 276 does not appreciably widen after metal layer 120 is reached and while etching continues within vias 277 and 278. Thereafter, via 277 is completed when patterned conductive layer 115 is reached, and via 278 is completed when conductive layer 110 is reached. When the last conductive layer is reached, (*i.e.,* layer 110 in the case of FIG. 2,) etching is complete and etching is stopped. According to the present invention, the vias all have a high aspect ratio, and have an average diameter which is approximately equal to the average diameter of the opening in the overlying mask.

The next step in the process (405) is to fill the vias that have been formed with conductive material. There are a number of ways of filling vias that are conventional and well-known to those skilled in the art. The particular method used will depend on the materials and dimensions used in the structure. A plating technique is presently preferred for vias that are sufficiently wide to accommodate a plating solution. Other possible methods include selective CVD, or sputtering with etch back and/or mechanical lapping.

After the vias have been filled, conventional processing of the multichip module continues (step 406) in accordance with prior art techniques. For example, in the embodiment of FIG. 2, patterned conductive layers 125 - 150 are formed, interleaved with polyimide layers 115a - 155f with interlayer vias 175. Then surface contact pads 160 are formed. In the embodiment of FIG. 3, contact pads 160 are formed. Of course, depending on the structure other processes and features may be included.

While the present invention has been particularly described with respect to preferred embodiments, it will be appreciated that various alterations, modifications, and adaptations may be made based on the present disclosure, and are intended to be within the scope of the present invention. While the invention has been described in connection with what is presently considered to be the most practical and preferred embodiments, it is to be understood that the present invention is not limited to the disclosed embodiments but, to the contrary, is intended to cover various modifications and equivalents that are within the scope of the appended claims.

## Claims

1. A method of forming a high aspect ratio via, comprising the steps of:
   forming a layer of polymeric material, said layer having a thickness greater than 20 microns,
   providing a mask over said layer of polymeric material said mask having an opening therein for defining the diameter of said via,
   using electron cyclotron resonance etching to remove the polymeric material from said layer beneath said mask, whereby a high aspect ratio via is formed in said layer.

2. A one-step method of forming high aspect ratio vias in a multilayered substrate, comprising:
   providing a multilayered substrate having a plurality of conductive layers at different levels therein, said conductive layers being separated by insulating layers,
   positioning a mask in proximity to the top surface of said multilayered substrate, said mask having a plurality of openings corresponding to vias to be formed within said multilayered substrate,
   simultaneously anisotropically removing the insulating material beneath each of said openings such that vias having substantially the same dimensions as the overlying openings are formed, said vias extending from the conductive layers to the top surface of the multilayered substrate.

3. The method of Claim 2 wherein said step of simultaneously anisotropically removing said insulating material is performed using electron cyclotron resonance etching.

4. The method of Claim 2 wherein said step of simultaneously anisotropically removing said insulating material is performed using reactive ion etching.

5. The method of Claim 2, 3, or 4, wherein at least some of said vias have a height greater than 20 microns.

6. The method of Claim 2, 3, 4 or 5, wherein at least some of said vias have an aspect ratio greater than 3 to 1.

7. The method of any of claims 2 to 6, wherein said insulating material is a polymeric material.

8. The method of Claim 7 wherein said polymeric material is a polyimide.

9. A multilayered substrate for a multichip module, comprising:
   a plurality of conductive layers,
   a plurality of insulating layers interleaved between said conductive layers,
   a plurality of vias formed within said substrate, each said via extending from a substantially planar surface to one of said conductive layers, such that said vias are of different heights, at least some of said vias having an aspect ratio greater that 3 to 1 and a height greater than 20 microns, each of said vias having a smoothly continuous wall.

10. A capacitor structure for use in a multichip module, said capacitor structure being embedded within the layers of a multilayered, multichip module, comprising,
    a first capacitor plate comprising a first patterned conductive layer,
    a first polyimide dielectric layer overlying said first patterned conductive layer, said polyimide layer having a thickness less than 5 microns,
    a second capacitor plate overlying said first polyimide dielectric layer said second capacitor plate comprising a second patterned conductive layer,
    a second polyimide dielectric layer overlying said second capacitor plate layer, said second polyimide dielectric layer having a thickness greater than 10 microns, and

at least one via continuously extending through said first and second dielectric layers to electrically contact said first capacitor plate layer.

11. The capacitor structure of claim 10 comprising a second via extending through said second dielectric layer to electrically contact said second capacitor plate.

12. The capacitor structure of claim 11 wherein said first and second vias are simultaneously formed by etching through an etch mask.

FIG. 1

FIG. 2

FIG. 3

Provide Multichip
ModuleSubstrate —401

Form A Plurality of
Interleaved Conductive —402
and Dielectric Layers
Over The Substrate

Form Etch Mask Over
Top Dielectric Layer
Having Openings Defining —403
A Plurality of Via Positions

Anisotropically Etch
To Form A Plurality of —404
High Aspect Ratio
Vias Extending to Different
Conductive Layers

Fill vias With
Conductive Material —405

Continue Processing —406

FIG. 4

FIG. 5